# EUROPEAN PATENT APPLICATION

(11) **EP 4 718 480 A1**
(43) Date of publication of application: **01.04.2026**
(21) Application number: 25195419.4
(22) Date of filing: 12.08.2025
(51) Int. Cl.: H01F 17/00, H05K 1/18, H01F 17/04

(54) **PRINTED CIRCUIT BOARDS WITH INDUCTORS IN THE MOUNTING HOLES**

(30) Priority: 25.09.2024 US 202418895796
(71) Applicant: INTEL Corporation, Santa Clara, CA 95054 (US)
(72) Inventor: LIM, Min Suet, Gelugor, Penang (MY); ALVAREZ MATA, Luis, Paraiso (CR); GO, Jia Yan, Kulim (MY); KAPILA, Smit, Bangalore (IN); KOTEHAL, Chaitra, Bengaluru (IN); KU, Jeff, Taipei (TW); KULKARNI, Shantanu, Hillsboro, OR (US); MANSUKOSKI, Kari, Hillsboro, OR (US); MISHRA, Surya Pratap, Portland, OR (US)
(74) Representative: Rummler, Felix

(57) **Abstract**

Systems, apparatus, articles of manufacture, and methods are disclosed for inductors of voltage regulators that are built into and/or around mounting holes of a printed circuit board. An example apparatus includes a printed circuit board that includes a plurality of layers and a mounting hole extending through the plurality of layers, and an inductor at least partially in the mounting hole between two or more of the plurality of layers.

## Description

### BACKGROUND

Electronic devices such as laptop computers include voltage regulators. Voltage regulators maintain the voltage of a power source within a range that is acceptable to the electrical components using that voltage.

### BRIEF DESCRIPTION OF THE DRAWINGS

FIG. 1 is a cross-sectional view of a portion of an example electronic device showing an example inductor in an example mounting hole of an example printed circuit board in accordance with teachings of this disclosure.
FIG. 2 is an isolated view of an example inductor incorporated in the printed circuit board of FIG. 1.
FIG. 3 is an exploded view of example layers of the printed circuit board with the inductor of FIG. 1.
FIG. 4 is an illustration of the inductor windings of FIGS. 1-3.
FIG. 5 is a cross-sectional view of a portion of an example electronic device showing another example inductor in an example mounting hole of an example printed circuit board in accordance with teachings of this disclosure.
FIG. 6A is an isolated view of an example metal coil that can be used in the mounting hole of FIG. 5.
FIG. 6B is an isolated view of another example metal coil that can be used in the mounting hole of FIG. 5.
FIG. 7 is a cross-sectional view of a portion of the electronic device of FIG. 5 with example magnetic resin adjacent the inductor.
FIG. 8 is a flowchart representative of an example process to form the printed circuit board and inductor of FIG. 7.

In general, the same reference numbers will be used throughout the drawing(s) and accompanying written description to refer to the same or like parts. The figures are not necessarily to scale. Instead, the thickness of the layers or regions may be enlarged in the drawings.

### DETAILED DESCRIPTION

Electronic devices such as computers include a central processing unit (CPU) and other power consuming electrical components. Voltage regulators are used to regulate or maintain the voltage of a power source such as battery within a limit or range that is acceptable to the power consuming electrical components using that voltage. Voltage regulators are circuits that create and maintain a fixed output voltage, regardless of fluctuations in the input voltage. Voltage regulators include multiple components such as a field-effect transistor (FET), a capacitor, and an inductor. The size of a voltage regulator is proportional to the maximum current and thermal design current properties of the component the voltage regulator maintains power for. As the power and current demands of electronic devices increase, the physical size and/or number of phases of a voltage regulator also increases to meet the demand. The chassis size of the electronic device, number of fans, and/or fan sizes limit space available for voltage regulators, which limits the physical size of the voltage regulator.

In addition, CPUs, voltage regulators, and other components are mounted to a printed circuit board such as a main board. Printed circuit boards include apertures or holes to receive mechanical fasteners to couple components to the printed circuit board. Fasteners include, for example, screws, rivets, thermal mechanical loading mounting screws, etc. Some fasteners are positioned in proximity to components the fasteners mount for loading purposes. For example, thermal mechanical loading mounting screws are positioned near System on Chip (SOC) dies or packages to provide sufficient loading to die. However, the locations of the mounting holes where the fasteners are coupled may coincide with a location a voltage regulator should be positioned to deliver power efficiently to the SOC with a low load line.

Examples disclosed herein include inductors of voltage regulators that are built into mounting holes of a printed circuit board. The inductors include a core and windings or a coil (e.g., copper wire wound into a coil) around the core. In some examples, the windings or coil of the inductor are built into layers of a printed circuit board. In some examples, mechanical load screws or other fasteners can form the core. Placing the inductors of the voltage regulators in the mounting holes allows the voltage regulators to be close to the component the voltage regulator maintains power for (e.g., the SOC).

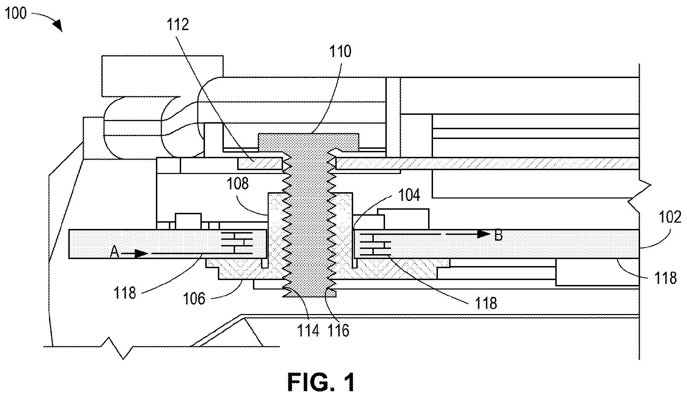

FIG. 1 is a cross-sectional view of a portion of an example electronic device 100 that includes an example printed circuit board 102. The printed circuit board 102 includes a plurality of substrates or layers. In some examples, there are ten layers. In some examples, there are eleven layers. In some examples, there are twelve layers. In other examples, there are other numbers of layers. The printed circuit board 102 includes an example mounting hole 104 that extends through the plurality of layers of the printed circuit board 102. The mounting hole 104 is used to mount components to the printed circuit board 102.

The electronic device 100 also includes an example back plate 106. The back plate 106 performs stiffening function to support the printed circuit board 102. The back plate has an extension or standoff 108. The standoff 108 extends through the mounting hole 104. The standoff 108 receives an example fastener 110. The fastener 110 secures a component 112 such as thermal module, CPU, etc. to the printed circuit board 102. The standoff 108 includes internal threads 114 that mate with external threads 116 of the fastener 110. In the illustrated example, the standoff 108 and the fastener 110 support the component 112 a distance above or away from the printed circuit board 102. In some examples, the fastener 110 is a load screw. In other examples, other types of fasteners such as rivets, etc. may be used.

The electronic device 100 includes an example coil 118 that is formed in, around, and/or adjacent to the mounting hole 104. In this example, the coil 118 is a coil structure that is formed of copper traces within and between the layers of the printed circuit board 102. In the illustrated example, the coil 118 is formed in two or more of the layers of the printed circuit board 102.

In some examples, the back plate 106 includes metal. In some examples, the back plate 106 includes silicon steel. In some examples, the fastener 110 includes metal. In some examples, the fastener 110 includes silicon steel. In some examples, the coil 118 includes metal. In some examples, the coil 118 includes copper. In some examples, the back plate 106 and/or the fastener 110 include other materials or combination of materials including ferrite, iron, other steel-based materials, etc.

The coil 118 surrounds at least a portion of the fastener 110. In the illustrated example, the standoff 108 is interposed between the coil 118 and the fastener 110. In the example of FIG. 1, the standoff 108, the fastener 110, and the coil 118 form an inductor of a voltage regulator. The fastener 110 and/or the standoff 108 act as a magnetic core for the inductor. The coil 118 includes an example trace or input A that is communicatively coupled to a power supply. For example, the input A may be coupled to a MOSFET of a power supply. The coil 118 includes an example trace or output B that is communicatively coupled to a power consuming component. For example, output B may be coupled to a power rail of an SOC. The standoff 108, the fastener 110, and the coil 118 (i.e., the inductor) work with other components of a voltage regulator to regulate the voltage and power distribution from the power supply to the power consuming component.

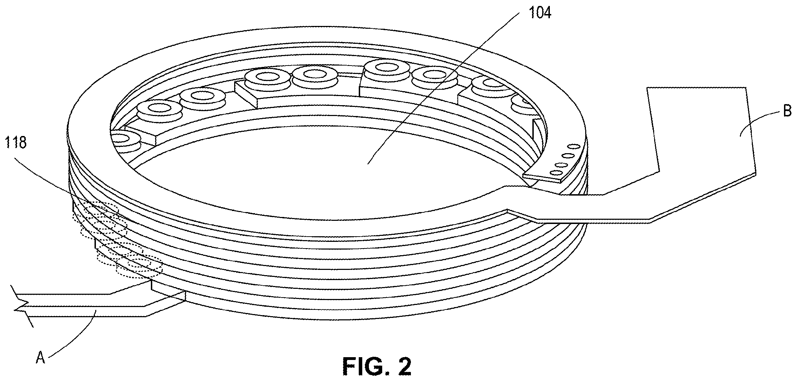

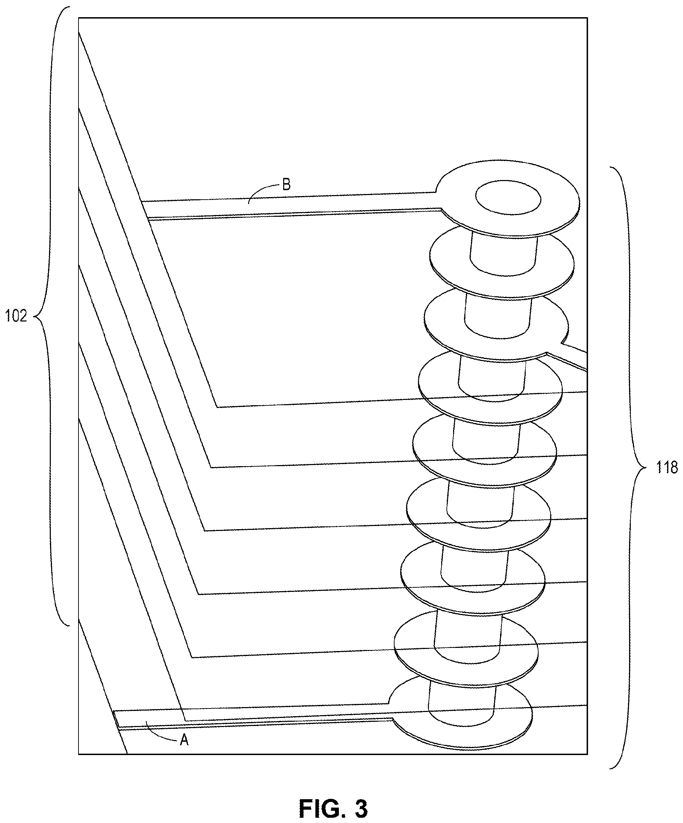

FIG. 2 is an isolated view of the coil 118 of FIG. 1. FIG. 3 is an exploded view of example layers of the printed circuit board 102 with the coil 118 of FIG. 1. The windings, coils, or turns of the coil 118 are stacked through the layers of the printed circuit board 102. Respective windings of the coil 118 are connected to an adjacent winding at another layer through vias of the printed circuit board 102. Each ring around the mounting hole 104 is considered a winding. In some examples, the coil 118 includes two windings. In some examples, the coil 118 includes a number of windings that is two less than the number of layers of the printed circuit board 102. For example, if the printed circuit board 102 has twelve layers, the coil 118 may have ten windings. In some examples, the coil 118 is inset within the printed circuit board 102 such that the coil 118 is in the inner layers. For example, if the printed circuit board 102 has ten layers, the coil 118 can be formed in the second layer through the ninth layer (the penultimate layer). In some examples, the printed circuit board 102 includes twelve layers and is 1 millimeter thick, and the coil 118 is formed from a metal (e.g. copper) trace that is 30 microns thick.

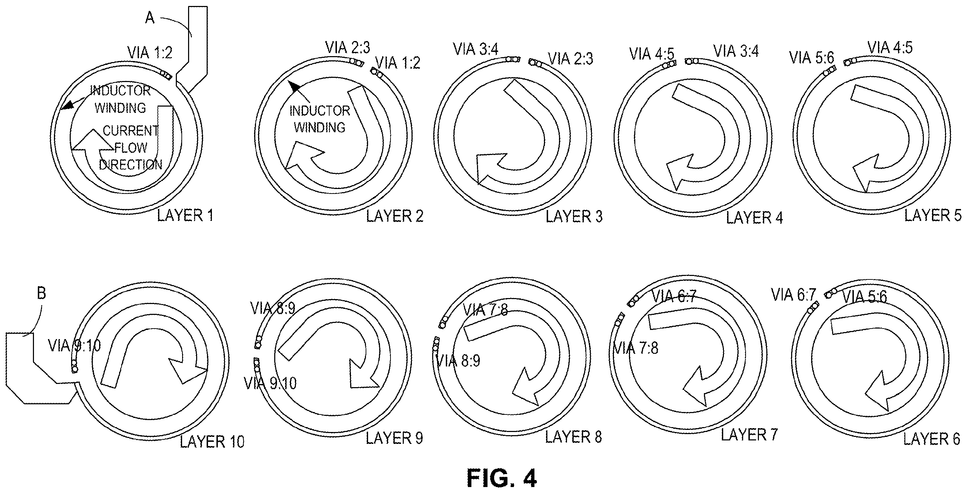

FIG. 4 is an illustration of the windings of the coil 118 in the different layers of the printed circuit board 102. The arrows in FIG. 4 illustrate example current flow through the coil 118. The number of windings of the coil 118 affects the inductance of the voltage regulator and the saturation current.

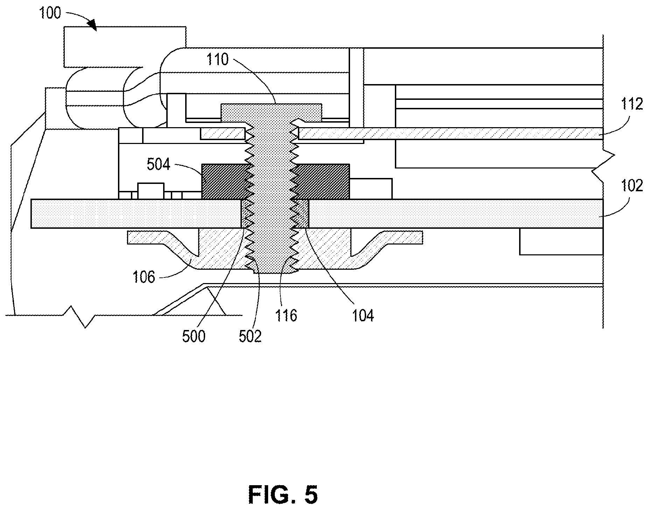

FIG. 5 is a cross-sectional view of a portion of the example electronic device 100 that includes an alternative inductor and voltage regulator. In the example of FIG. 5, the electronic device includes an example coil 500 of an inductor that is inserted or embedded into the mounting hole 104. In some examples, the coil 500 includes a metal insert. In some examples, the coil 500 includes a metal coil. In some examples, the coil 500 includes copper. In some examples, the coil 500 is held in the mounting hole 104 via a friction fit. In some examples, the coil 500 is held in the mounting hole 104 via an epoxy or other adhesive.

In the illustrated example, the mounting hole 104 of the printed circuit board 102 does not have internal threads to secure the fastener 110. In addition, in this example, the coil 500 also does not have internal threads to secure the fastener 110. Instead, the back plate 106 includes an example boss 502 that includes internal threads that engage the external threads 116 of the fastener 110. In some examples, there is an example nut 504 to also secure the fastener 110. In the example of FIG. 5, the fastener 110 and the coil 118 form an inductor of a voltage regulator. In some examples, the nut 504, along with the fastener 110 may form part of the magnetic core of the inductor. In the example of FIG. 5, the back plate 106 can include other materials including, for example, nonmetal materials.

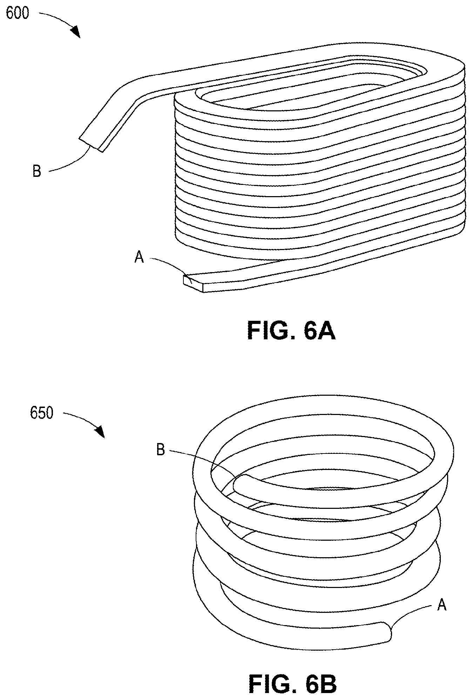

FIG. 6A is an isolated view of an example metal coil 600 that can be used as the coil 500 of FIG. 5. FIG. 6B is an isolated view of another example metal coil 650 that can be used as the coil 500 of FIG. 5. The metal coil 600 and the metal coil 650 includes ends that form the input A and output B of the coil 500. As noted above, the input A is coupled to a power supply, and the output B supplies regulated voltage to a power consuming component. The metal coil 600 includes more windings than the metal coil 650. The number of windings of the coil 118 affects the inductance of the voltage regulator and the saturation current.

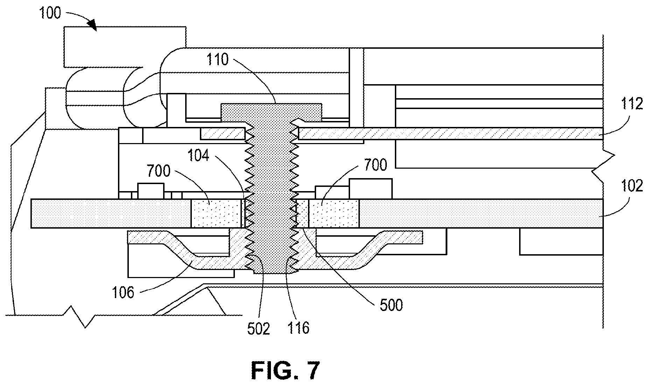

FIG. 7 is a cross-sectional view of a portion of the electronic device 100 with the coil 500 of FIG. 5. In the example of FIG. 7, an example resin 700 is included in the mounting hole 104 around the coil 500. The coil 500 is embedded in and/or surrounded by the resin 700. The resin 700 is magnetic. In some examples, the resin 700 extends into the printed circuit board 102 between layers of the printed circuit board 102. In some examples, the resin 700 forms a magnetic core. In the example of FIG. 7, the fastener 110, the coil 118, and the resin 700 form an inductor of a voltage regulator. The magnetic field generated by the fastener 110 and the coil 500 in the example of FIG. 5 is enhanced by the resin 700 in the example of FIG. 7. The resin 700 creates a wider cross-sectional diameter of the magnetic core. Thus, the magnetic field has a larger area with the resin 700 than without the resin 700. The larger magnetic field enhances the inductive properties of the voltage regulator.

In some examples, the resin 700 includes a magnetic material within a neutral (e.g., non-magnetic, non-conductive) matrix. In some examples, the matrix is a thermoplastic or thermosetting organic polymer that includes epoxy resins, polyamide resins, polyimide resins, polysulfones. Inorganic materials such as silica filler and/or silicates may also be included.

In some examples, the magnetic material includes, without limitation, one or more of iron, nickel, nickel-iron alloys such as Mu metals and/or permalloys. In some examples, the magnetic material includes lanthanide and/or actinide elements. In some examples, the magnetic material includes cobalt-zirconium-tantalum alloy (e.g., CZT). In some examples, the magnetic material includes ferrite materials including barium and/or strontium cations. In some examples, the magnetic material includes ferrite materials including any of nickel, manganese, zinc, and/or cobalt cations, in addition to iron. In some examples, the magnetic material includes semiconducting or semi-metallic Heusler compounds and non-conducting (ceramic) ferrites. Heusler compounds may include any of manganese, iron, cobalt, molybdenum, nickel, copper, vanadium, indium, aluminum, gallium, silicon, germanium, tin, and/or antimony. In some examples, the magnetic material includes Pt, Pd, W, Ce, Al, Li, Mg, Na, Cr₂O₃, CoO, Dy, Dy₂O, Er, Er₂O₃, Eu, Eu₂O₃, Gd, Gd₂O₃, FeO, Fe₂O₃, Nd, Nd₂O₃, KO₂, Pr, Sm, Sm₂O₃, Tb, Tb₂O₃, Tm, Tm₂O₃, V, V₂O₃ or epoxy material with particles of a magnetic alloy. A magnetic alloy can be an alloy formed of one or more of: Pt, Pd, W, Ce, Al, Li, Mg, Na, Cr, Co, Dy, Er, Eu, Gd, Fe, Nd, K, Pr, Sm, Tb, Tm, or V. While some of the magnetic materials are conductors, the resin 700 is electrically non-conductive to avoid short-circuiting the printed circuit board 1025.

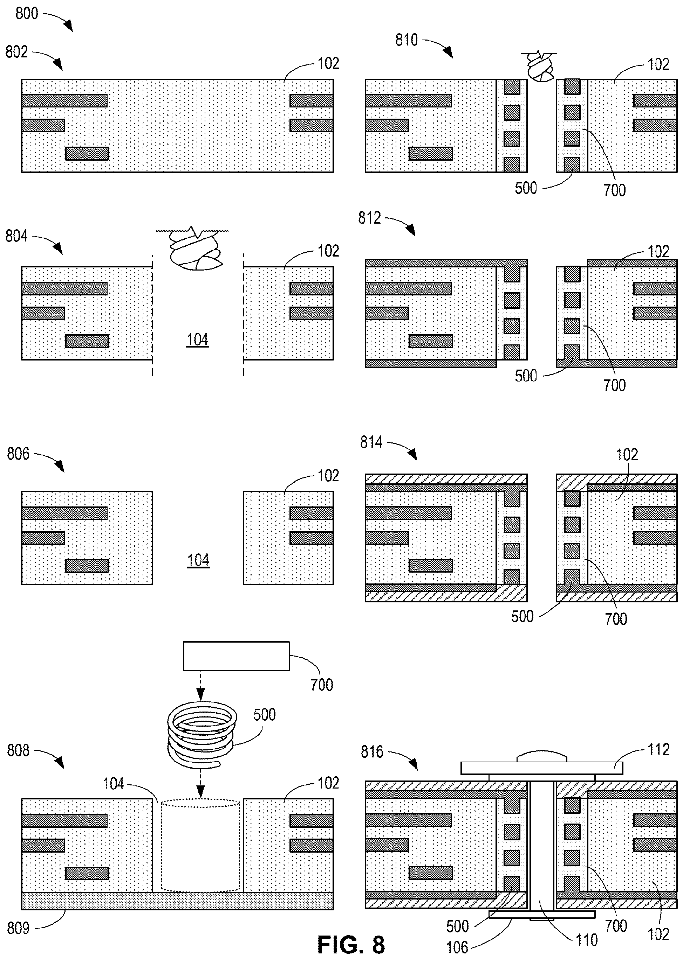

FIG. 8 is a flowchart representative of an example process 800 to form the printed circuit board 102 and coil 500 with the resin 700 of FIG. 7. At block 802, a substate that will form the printed circuit board 102 is laminated to form, for example, a copper clad laminate. At block 804, the mounting hole 104 is mechanically formed via, for example, a mechanical drill. At block 806, the substrate is electroplated.

At block 808, a tape 809 is added to the bottom of the substrate, the coil 500 is inserted into the mounting hole 104, and the resin 700 is added. At block 810, the tape 809 is removed after the resin 700 sets or cures. A mechanical drill removes resin 700 from the center of the coil 500. At block 812, there is further plating and etching of the printed circuit board 102. At block 814, an insulating ink such as solder resist and surface finishing are added to the printed circuit board 102. At block 816, the fastener 110, back plate 106, and component 112 are assembled.

Examples disclosed herein include inductors of voltage regulators that are built into and/or around mounting holes of a printed circuit board. In some examples, the inductors also are built into layers of a printed circuit board at, near, adjacent, and/or surrounding the mounting holes. These examples reduce the number of inductors of voltage regulators that are coupled to areas of a printed circuit board outside of the mounting holes. Thus, the regions of the printed circuit boards traditionally dedicated to inductors of voltage regulators are free to support other components and/or the size of the printed circuit board can be reduced to provide more remove for other components such as fans and/or to reduce the size of the electronic device. For example, a traditional inductor of a voltage regulator may require 1 mm² of space on a printed circuit board. With the examples disclosed herein, the inductor fits into a mounting hole that is already part of the printed circuit board. Thus, in this example, 1 mm² of space is saved without the traditional inductor.

The inductance saturated current values of examples disclosed herein may depend on the number of windings of the inductors, the materials of the fasteners, the materials of the resin, the diameter of the fastener and/or the resin, etc. For example, different silicon steels with different relative permeabilities lead to voltage regulators with difference inductance values. For example, silicon steel with relative permeabilities of 50, 70, and 100 achieve inductance values of 1.6 microhenrys (µH), 2.2µH, and 3.3µH respectively and saturation currents of 11.2 amperes (A), 8A, and 5.6A, respectively. These values are sufficient regulating VddQ rail (CPU voltage) and/or any other rail with similar specifications in other current and/or future platforms. Thus, these values also are sufficient to remove a traditional inductor of a voltage regulator from elsewhere on the printed circuit board.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a," "an," "first," "second," etc.) do not exclude a plurality. The term "a" or "an" object, as used herein, refers to one or more of that object. The terms "a" (or "an"), "one or more," and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real-world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

Example systems, apparatus, articles of manufacture, and methods are disclosed for inductors of voltage regulators that are built into and/or around mounting holes of a printed circuit board. Example 1 includes an apparatus that includes a printed circuit board that includes a plurality of layers and a mounting hole extending through the plurality of layers, and an inductor at least partially in the mounting hole between two or more of the plurality of layers.

Example 2 includes the apparatus of Example 1, including: a back plate including a standoff, the standoff inserted in the mounting hole; and a fastener coupled to the standoff.

Example 3 includes the apparatus of Example 2, wherein the fastener and standoff include a silicon steel.

Example 4 includes the apparatus of any of Examples 1-3, wherein the inductor is formed in the two or more of the plurality of layers.

Example 5 includes the apparatus of any of Examples 1-4, wherein the inductor includes a number of windings, the number of windings is two less than a number of the plurality of layers.

Example 6 includes the apparatus of any of Examples 1-5, wherein the inductor includes an input that is communicatively coupled to a power supply and an output that is communicatively coupled to a power consuming component.

Example 7 includes the apparatus of any of Examples 1-6, wherein the inductor is a metal coil.

Example 8 includes the apparatus of Example 7, wherein at least a portion of the inductor is inserted in the mounting hole.

Example 9 includes the apparatus of Example 8, wherein the inductor includes a magnetic resin between the plurality of layers and around the metal coil.

Example 10 includes the apparatus of any of Examples 1-9, wherein the inductor includes a magnetic resin between the plurality of layers.

Example 11 includes the apparatus of any of Examples 1-10, further including a fastener in the mounting hole, the fastener forming a core of the inductor, and the inductor forming a portion of voltage regulator.

Example 12 includes an inductor of a voltage regulator. The inductor of Example 12 includes: a coil in or around a mounting hole of a printed circuit board having a plurality of layers, the coil between two or more of the plurality of layers of the printed circuit board; and a fastener of metal in the mounting hole, the coil surrounding at least a portion of the fastener.

Example 13 includes the inductor of Example 12, including a standoff of a back plate, the fastener coupled to the standoff, the standoff interposed between the fastener and the coil.

Example 14 includes the inductor of Example 13, wherein the fastener and the standoff include silicon steel and the coil includes copper.

Example 15 includes the inductor of any of Examples 12-14, wherein the plurality of layers of the printed circuit board includes a first number of layers, and the coil includes a second number of windings, the second number less than the first number.

Example 16 includes the inductor of any of Examples 12-15, wherein the coil includes a first trace coupled to a power supply and a second trace coupled to a power rail.

Example 17 includes the inductor of any of Examples 12-16, wherein the coil is formed within the plurality of layers of the printed circuit board.

Example 18 includes the inductor of any of Examples 12-17, wherein the coil includes a metal insert in the mounting hole.

Example 19 includes the inductor of Example 18, wherein the coil is embedded in a magnetic resin.

Example 20 includes the inductor of Example 19, wherein the magnetic resin extends between two or more layers of the plurality of layers of the printed circuit board.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a printed circuit board including:
a plurality of layers; and
a mounting hole extending through the plurality of layers; and
an inductor at least partially in the mounting hole between two or more of the plurality of layers.

2. The apparatus of claim 1, including:
a back plate including a standoff, the standoff inserted in the mounting hole; and
a fastener coupled to the standoff.

3. The apparatus of claim 2, wherein the fastener and the standoff include a silicon steel.

4. The apparatus of any of claims 1-3, wherein the inductor is formed in the two or more of the plurality of layers.

5. The apparatus of any of claims 1-4, wherein the inductor includes a number of windings, the number of windings is two less than a number of the plurality of layers.

6. The apparatus of any of claims 1-5, wherein the inductor includes an input that is communicatively coupled to a power supply and an output that is communicatively coupled to a power consuming component.

7. The apparatus of any of claims 1-6, wherein the inductor is a metal coil.

8. The apparatus of any of claims 1-7, wherein at least a portion of the inductor is inserted in the mounting hole.

9. The apparatus of any of claims 1-8, wherein the inductor includes a magnetic resin between the plurality of layers and around the metal coil.

10. The apparatus of claim 1, wherein the inductor includes a magnetic resin between the plurality of layers.

11. The apparatus of any of claims 1-10, further including a fastener in the mounting hole, the fastener forming a core of the inductor, and the inductor forming a portion of voltage regulator.

12. The apparatus of any of claims 1-11, wherein the inductor includes a coil, and the apparatus includes a fastener of metal in the mounting hole, the coil surrounding at least a portion of the fastener.

13. The apparatus of any of claims 1-12, including a standoff of a back plate, the fastener coupled to the standoff, the standoff interposed between the fastener and the coil, wherein the fastener and the standoff include silicon steel and the coil includes copper.

14. The apparatus of any of claims 1-13, wherein the coil includes a metal insert in the mounting hole.

15. The apparatus of any of claims 1-14, wherein the coil is embedded in a magnetic resin.
